(19) Europäisches Patentamt
European Patent Office
Office européen des brevets

(11) **EP 0 290 790 B1**

(12) **EUROPÄISCHE PATENTSCHRIFT**

(45) Veröffentlichungstag und Bekanntmachung des Hinweises auf die Patenterteilung:
**30.07.1997  Patentblatt 1997/31**

(51) Int Cl.⁶: **H03H 17/02**, H04J 4/00

(21) Anmeldenummer: **88105684.0**

(22) Anmeldetag: **09.04.1988**

(54) **Filterbank**

Filter bank

Banc de filtres

(84) Benannte Vertragsstaaten:
**FR GB IT NL**

(30) Priorität: **14.05.1987  DE 3716018**

(43) Veröffentlichungstag der Anmeldung:
**17.11.1988  Patentblatt 1988/46**

(73) Patentinhaber: **ROBERT BOSCH GMBH**
**70442 Stuttgart (DE)**

(72) Erfinder: **Göckler, Heinz, Dipl.-Ing.**
**D-7150 Backnang (DE)**

(56) Entgegenhaltungen:
**DE-U- 8 706 928**

**Beschreibung**

Die Erfindung bezieht sich auf eine Filterbank gemäß Oberbegriff der Patentansprüche 1 oder 2.

Eine solche Filterbank ist bekannt durch den Aufsatz von Del Re und Emiliani "An analytic signal approach for transmultiplexers: theory and design" in IEEE Transactions on Communications, Vol. Com-30, No. 7, July 1982, Seiten 1623 ff.

Eine solche Filterbank zum Multiplexen oder Demultiplexen von FDM-Einzelkanälen wird hauptsächlich in sogenannten Transmultiplexern eingesetzt, welche der Umsetzung von FDM in TDM bzw. umgekehrt dienen und z.B. in der Satellitentechnik oder im Telefonnetz Anwendung finden. Gerade in der Satellitentechnik ist es oberstes Gebot, dafür zu sorgen, daß die Nutzlast so gering wie möglich ausfällt.

Der vorliegenden Erfindung lag deshalb die Aufgabe zugrunde, eine Filterbank der eingangs genannten Art anzugeben, bei der der Schaltungsaufwand vermindert ist bzw. bei der verbesserte Systemeigenschaften bei unverändertem Schaltungsaufwand zu erzielen sind.

Diese Aufgabe wurde gelöst mit den kennzeichnenden Merkmalen des Patentanspruches 1 bzw. 2.

Die erfindungsgemäße Filterbank weist den Vorteil eines kleineren Schaltungsaufwandes auf bzw. den Vorteil besserer Systemeigenschaften bei gleichem Schaltungsaufwand. Vorteilhafte Ausgestaltungen der Erfindung ergeben sich durch die Unteransprüche.

Zwar sind in dem Buch von Crochiere und Rabiner "Multirate digital signal processing" Prentice Hall 1983, mehrstufige Filterlösungen angegeben, jedoch lediglich für Filter mit reellwertigen Koeffizienten.

Es folgt nun die Beschreibung der Erfindung anhand der Figuren.

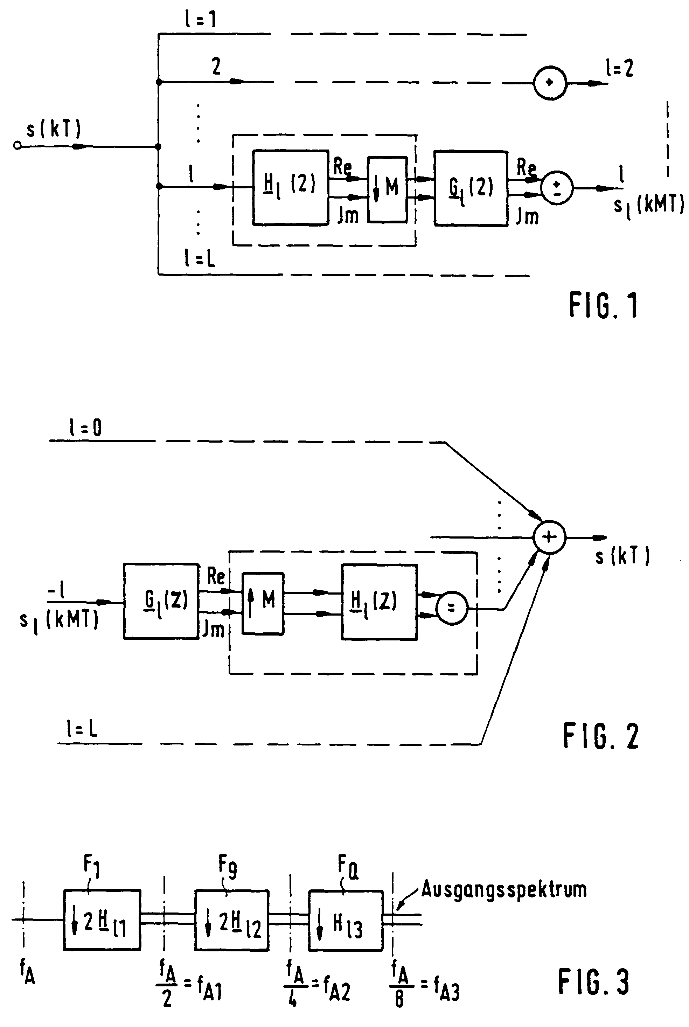

Die Figur 1 zeigt das Blockschaltbild eines FDM-Demultiplexers gemäß dem Stande der Technik, die Figur 2 einen FDM-Multiplexer ebenfalls nach dem Stande der Technik.

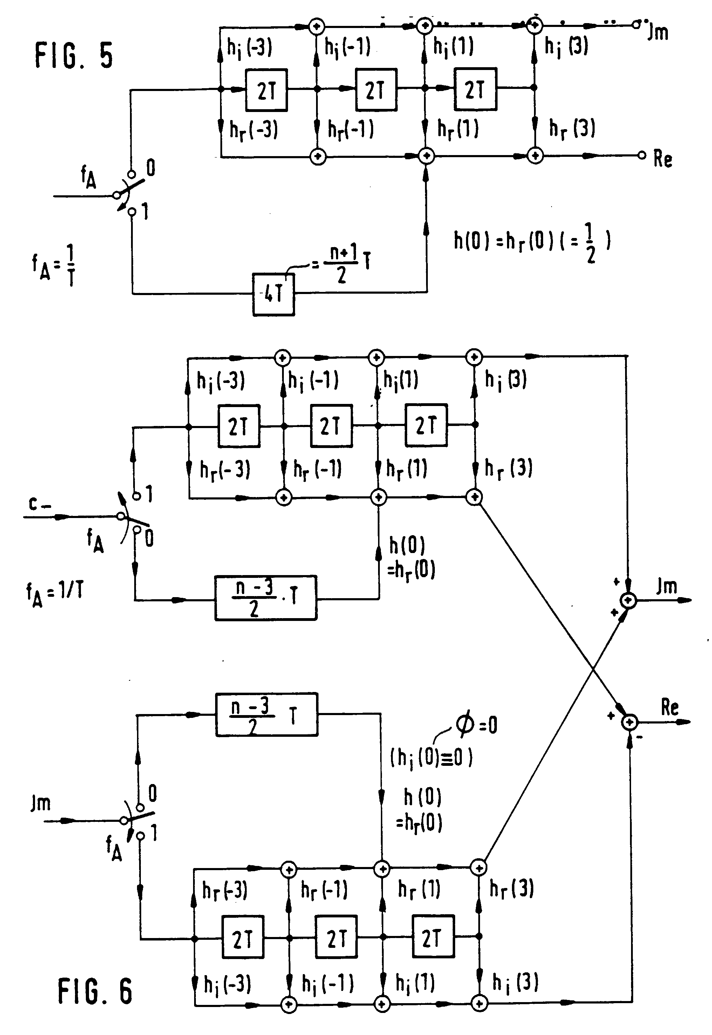

Ein Ausführungsbeispiel zeigt das Blockschaltbild nach Figur 3 (Figur 5 und 6) und eine spektrale Darstellung derselben ist in den Figuren 4a bis 4d aufgezeigt. Ein detaillierteres Ausführungsbeispiel für eine reelle Eingangsstufe mit komplexem Ausgangssignal zeigt Figur 5, während die Figur 6 ein Ausführungsbeispiel für eine Filterstufe mit komplexem Eingangs- und Ausgangssignal beschreibt.

Die Figur 1 zeigt einen FDM-Demultiplexer für L Einzelkanalsignale, wobei das FDM-Signal $s(kT)$ auf L Parallelschienen verteilt wird, dort gefiltert wird in einem Filter mit der Übertragungsfunktion $\underline{H}_I(z)$ für den I-ten Einzelkanal, dessen komplexwertiges Ausgangssignal mit der um den Faktor M reduzierten Abtastrate abgetastet ist und dem Bandbegrenzungsfilter $\underline{G}_I(z)$ zugeführt wird, dessen ebenfalls komplexwertiges Ausgangssignal mittels einer Additions-/Subtraktion-Verknüpfungsschaltung z.B. wieder zu einem reellwertigen Signal, dem Einzelsignal des Kanals mit der Nummer I verknüpft wird.

Die Figur 2 zeigt einen FDM-Multiplexer, welcher aus dem Demultiplexer der Figur 1 in einfacher Weise durch inverse Funktion, d.h. durch eine Betriebsweise in Rückrichtung erhalten wird.

Gegenstand der vorliegenden Erfindung ist es, den Teil des Filters, der durch die gestrichelte Linie eingerahmt ist, durch eine Filterkaskade gemäß Anspruch 1 bzw. 2 zu ersetzen. Die Blockschaltung sieht beispielsweise aus wie die gemäß der Figur 3. Hier besteht die Kaskade aus drei Stufen, welche jeweils die Abtastrate um den Faktor 2 vermindert und wobei die erste Stufe aus dem reellwertigen Eingangssignal ein komplexwertiges Ausgangssignal und jede weitere Stufe aus dem komplexwertigen Eingangssignal ein komplexwertiges Ausgangssignal bildet.

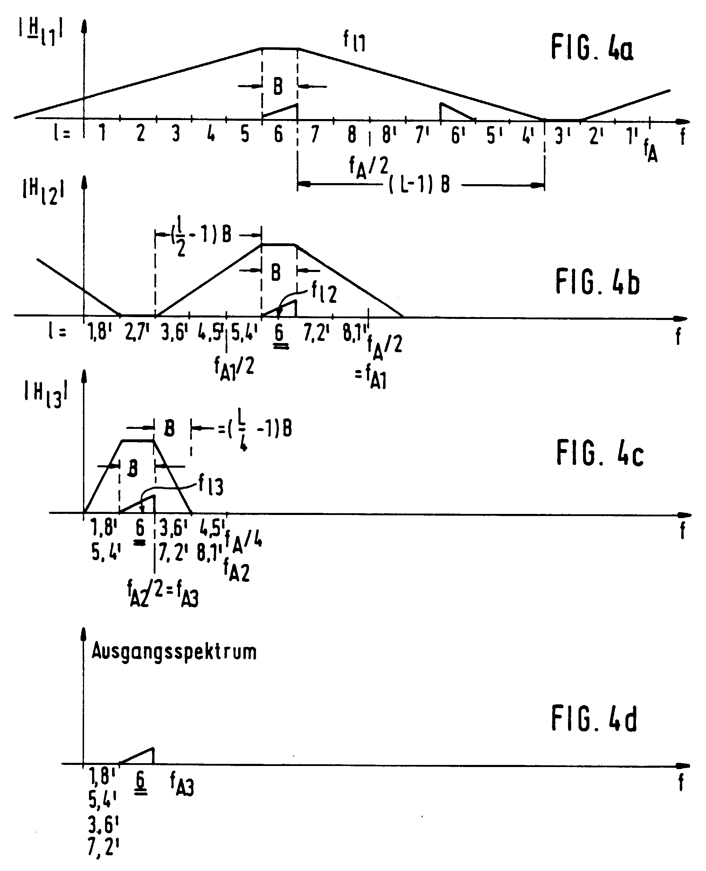

Die spektrale Darstellung hierzu ist den Diagrammen der Figur 4a bis 4d zu entnehmen, wobei die Darstellung für den 6. Kanal von L=8 Kanälen und einer Abtastratenverminderung von M=8 erfolgt. Die Figur 4a zeigt die Übertragungsfunktion $|\underline{H}_{I1}|$ der ersten Kaskadenstufe aufgetragen über der Frequenz f mit dem Durchlaßbereich der Breite B für den Kanal 1=6, mit der Mittenfrequenz $fl1 = (I-1/2) B$ dieses Durchlaßbereiches und mit dem sehr flachen Übergangsbereich von jeweils B . (L-1) = 7B symmetrisch zur Mittenfrequenz. Die Abtastfrequenz $f_A$ liegt bei 2 . L . B = 16B. In der Figur 4b ist die Übertragungsfunktion $|\underline{H}_{I2}|$ der zweiten Kaskadenstufe gezeichnet, deren Übertragungsbereich ebenfalls symmetrisch zum Kanal I=6 liegt, aber einen Übergangsbereich von (L/2 - 1) . B symmetrisch zur Mittenfrequenz des Kanals $6:f_{I2} = f_{I1}$ aufweist. Aufgrund der Abtastratenreduzierung um den Faktor 2 in der ersten Stufe fallen die Signalspektren der Kanäle 1 und 8', 2 und 7', 3 und 6', 4 und 5', 5 und 4', 7 und 2', 8 und 1' jeweils aufeinander, wobei die Spektren der Kanäle 2 und 7' auf den Sperrbereich des 2. Filters fallen und das Spektrum des Kanal 6 in den Durchlaßbereich fällt.

Aufgrund der weiteren Abtastratenreduzierung un den Faktor 3 fallen die Frequenzbereiche der Kanäle 1, 8', 5 und 4' aufeinander und zwar auf den Bereich des ersten Kanals, sowie die Frequenzbereiche der Kanäle 3, 6', 7 und 2' auf den Bereich des dritten Kanals und die Frequenzbereiche der Kanäle 4, 5' und 8 und 1' auf den Bereich des vierten Kanals. Die Übertragungsfunktion $|\underline{H}_{I3}|$ der dritten Kaskadenstufe ist nun so ausgebildet, daß der Übertragungsbereich mit der Breite B direkt auf den Bereich des zweiten Kanals fällt, auf welchen Frequenzbereich aufgrund der Abtastrate $f_A{}^{II} = f_A/4$ das Spektrum des 6. Kanals ebenfalls fällt. Der Übergangsbereich dieser 3. Stufe weist ebenfalls die Breite B auf.

Nachzuholen ist, daß durch den Sperrbereich der 1. Filterstufe das Spektrum des Kanals 3', durch den Sperrbereich der 2. Filterstufe die Spektren 2 und 7' und nunmehr durch den Sperrbereich der 3. Stufe die Spektren der Kanäle 4, 5', 8 und 1' total unterdrückt werden.

In Figur 4d ist nun das Ausgangsspektrum gezeichnet, welches durch die weitere Halbierung der Abtastrate in der letzten Stufe entsteht, wobei das Ausgangsspektrum des 6. Kanals auf dem Frequenzbereich des 2. Kanals liegen bleibt, wobei aber die Restspektren der verbliebenen Kanäle 1, 8', 5, 4', 3, 6', 7 und 2' auf den Frequenzbereich des 1. Kanals zu liegen kommen.

Hier am Beispiel der Demultiplexbildung für den 6. Kanal gezeigt, kann in entsprechender Weise die Demultiplexbildung für die anderen Kanäle erfolgen.

Im folgenden sei noch gezeigt, wie der Aufwand anhand der Rechenoperationen pro Zeiteinheit bei der Schaltung gemäß Figur 3 geringer ist als bei der einstufigen Realisierung der Filterübertragungsfunktion $\underline{H}_I(z)$ gemäß Figur 1 bzw. 2. Voraussetzung sei, daß die einzelnen Filterstufen als komplexwertige Halbbandfilter realisiert sind. Der reelle FIR Halbbandfilter-Prototyp sei gegeben durch die Abtastwerte seiner Impulsantwort h(k) mit k = -(n-1)/2...+(n-1)/2 mit der Filterlänge n, wobei h(k) = 1/2 oder entsprechend skaliert ist für k = 0 und wobei h(k) = 0 ist für die Werte k = ±2, ±4 usw. Ein verallgemeinertes komplexwertiges Halbbandfilter gemäß der spektralen Darstellung der Figur 4 ergibt sich durch Modulation der Impulsantwort h(k) auf eine komplexe Trägerschwingung mit der Frequenz entsprechend der Mittenfrequenz $f_{Iq}$ der Lage des gewünschten Durchlaßbereichs des q-ten Filters der Kaskade (q = 1, ... Q; Q = natürliche Zahl). Es ist

$$\underline{h}_{Iq}(k) = h(k) \left[ \cos(2\pi k f_{Iq}/f_{Aq} + \emptyset) + j \sin(2 k f_{Iq}/f_{Aq} + \emptyset) \right]$$

$$= h_{Iqr}(k) + j h_{Iqi}(k),$$

wobei $f_{Aq}$ die jeweilige Abtastfrequenz und $f_{Iq}$ die jeweiligen stufenspezifische Mittenfrequenz und $\emptyset$ die Nullphase sind. Anders geschrieben lautet die Gleichung

$$\underline{h}_{Iq}(k) = h(k) \cdot e^{j}(2\pi f_{Iq}/f_{Aq} + \emptyset).$$

In der Figur 5 ist ein Blockschaltbild für ein Halbbandfilter mit reellwertigem Eingangs- und komplexwertigem Ausgangssignal wiedergegeben, welches sich in dem Demultiplexer gemäß Figur 1 bzw. 3 als 1. Stufe verwenden läßt. In Figur 6 ist eine Halbbandfilter für komplexwertige Eingangs- und Ausgangssignale gezeichnet, welches Halbbandfilter sich für die Stufe 2 und folgende des Demultiplexers gemäß Figur 1 bzw. 3 eignen.

Halbbandfilter mit reellwertigen Eingangssignalen und komplexwertigen Ausgangssignalen bzw. umgekehrt sind an sich in der deutschen Patentanmeldung P 36 21 737 und solche mit komplexwertigen Ein- und Ausgangssignalen in der deutschen Patentanmeldung P 37 05 209 vorgeschlagen worden; bei beiden Halbbandfiltertypen handelt es sich um eine solche mit Abtastratenänderung um den Faktor 2, wobei aber die Wahl der Mittenfrequenzen von Durchlaß- und Sperrbereich nur auf ganz bestimmte Werte eingeschränkt ist. Im Gegensatz dazu ist die Mittenfrequenz des Durchlaßbereiches der vorliegenden Halbbandfilter gemäß Figur 5 und 6 frei wählbar.

Die Verminderung des Gesamtaufwands der Mehrstufenanordnung kommt dadurch zustande, daß bei Filtern mit endlicher Impulsantwort die Filterlänge n proportional $f_A/\Delta f$ ist. Im Einstufenfall gemäß dem Stande der Technik ist $\Delta f = B$, die Abtastfrequenz $f_A \geq 2LB$; damit wird n = c · 2L, wobei c eine Konstante ist. Für L = 8 wird n = c · 16.

Für den Mehrstufenfall q = 1, 2, ... Q wird $\Delta f_q = (L/2^{q-1}-1) \cdot B$ mit der Abtastfrequenz $f_{Aq} \geq 2B \cdot L/2^{q-1}$. Damit wird die Filterlänge n der Stufe q: n = c · 2L/(L-1$^{q-1}$).

Für L = 8 ergeben sich für die 1. Stufe q = 1, n = c · 16/7.

Für die Stufe q = 2, n = c · 8/3) und

für die Stufe q = 3, n = c · 4.

Gegenüber dem Einstufenfall der Filterlänge n = c · 16 ergibt sich nun eine Gesamtstufenlänge von ungefähr n = c · 9.

Bei den Halbbandfiltern gemäß Fig. 5 und 6 ließe sich weiterhin eine Koeffizientensymmetrie vorteilhaft ausnutzen, wenn $h_i(-k) = -h_i(k)$ und $h_r(-k) = h_r(k)$ erfüllt ist. Unter Ausnutzung dieser Koeffizientensymmetrie läßt sich eine Aufwandsverminderung in folgendem Ausmaß erreichen.

Unter der Voraussetzung M = 64 = $2^6$ und der Abtastfrequenz $f_A^{VI} = f_A/64 = f_A/2^6$ ergibt sich für das Einstufenfilter $\underline{H}_I$ gemäß dem Stand der Technik die Gesamtfilterlänge n = 384 sowie eine Multiplikationsrate

$M_E = n \cdot f_A^{VI} = 384 \cdot f_A^{VI}$ und eine Additonsrate

$A_E = 2(n-1) \cdot f_A^{VI} = 766 f_A^{VI}$.

Bei einer Sechsstufenlösung mit einem Abtastreduktionsfaktor $M_q = 2$ für alle Stufen q ergeben sich für die Filter der Stufe 1 bis 3 eine Filterlänge von $n_q = 3$, für die Stufe 4 und 5 die Filterlänge $n_q = 7$ und für die Stufe 6 eine Filterlänge von $n_q = 11$. Die Multiplikationsraten errechnen sich zu

$$M_M = 1/2 \cdot (n_1 + 3) \, f_{A1} + \sum_{q=2}^{6}$$

$$(n_q + 3) \cdot f_{Aq} = \left[ 3 \cdot 32 + 6(16 + 8) + 10(4 + 2) + 14 \right] f_{A6}$$

$$= 314 \cdot f_{A6}.$$

Die Additionrate ergibt sich zu

$$A_M = n_1 \cdot f_{A1} + 2 \cdot \sum_{q=2}^{6}(n_q + 1) \cdot f_{Aq} = \left[ 3 \cdot 32 + 8(16+8) + 16(4+2) + 24 \right] \cdot f_{A6}$$

$$= 408 \cdot f_{A6}.$$

Damit ergeben sich sowohl bei der Gesamtfilterlänge als auch bei den Multiplikations- und Additionsraten z.T. erhebliche Verbesserungen. Hinzukommt, daß die erforderlichen Koeffizienten- und Signalwortlängen in den erfindungsgemäßen Mehrstufenlösungen aufgrund der kleinen Filterlängen $n_q$ kleiner als bei der Einstufenlösung sind, wodurch sich ein weiterer Aufwandsvorteil ergibt.

**Patentansprüche**

1. Filterbank zum Frequenzdemultiplexen von L Kanalsignalen, für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für reellwertige Eingangssignale und mit komplexwertigen Ausgangssignalen, mit am Ausgang um den Faktor M reduzierter Abtastrate, dadurch gekennzeichnet,

   daß mindestens eines der L Filter durch eine Kaskadierung von mindestens 2 Filtern mit jeweils komplexwertigen Koeffizienten realisiert ist,
   daß bei jedem dieser Filter ($F_1, \dots F_q, \dots F_Q$) die Abtastrate um den Faktor $M_q > 1$ reduziert ist, mit

   $$\prod_{q=1}^{Q} M_q = M,$$

   daß die Eingangsfilter ($F_1$) der Kaskade jeweils ein reellwertiges Eingangssignal aufnehmen und ein komplexwertiges Ausgangssignal abgeben und
   daß die anderen Filter der Kaskade jeweils ein komplexwertiges Eingangssignal aufnehmen und ein komplexwertiges Ausgangssignal abgeben.

2. Filterbank zum Frequenzmultiplexen von L Kanalsignalen, für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für komplexwertige Eingangssignale und reellwertige Ausgangssignale, mit am Ausgang um den Faktor M erhöhter Abtastrate, dadurch gekennzeichnet,

   daß mindestens eines der L Filter durch eine Kaskadierung von mindestens 2 Filtern mit jeweils komplexwertigen Koeffizienten realisiert ist,
   daß bei jedem dieser Filter ($F_1, \dots F_q, \dots FQ$) die Abtastrate um den Faktor $M_q > 1$ erhöht ist, mit

$$\prod_{q=1}^{Q} M_q = M,$$

daß die Q-1 ersten Filter ($F_1$, ... $F_q$, ... $F_{Q-1}$) der Kaskade jeweils ein komplexwertiges Eingangssignal aufnehmen und ein komplexwertiges Ausgangssignal abgeben und
daß die Ausgangsfilter der Kaskade jeweils ein komplexwertiges Eingangssignal aufnehmen und ein reellwertiges Ausgangssignal abgeben.

3. Filterbank nach Anspruch 1 oder 2, <u>dadurch gekennzeichnet</u>,
daß der Faktor M in 2 Faktoren zerlegt wird mit einer Zweier-Potenz $2^i$ als 1. Faktor und einem 2. Faktor, der gleich $M/2^i$ ist, mit i gleich einer natürlichen Zahl.

4. Filterbank nach Anspruch 3, <u>dadurch gekennzeichnet</u>,
daß der Zweier-Potenzfaktor $2^i$ durch eine Kaskade von i Filtern mit jeweils $M_q = 2$ realisiert ist.

5. Filterbank nach Anspruch 4, <u>dadurch gekennzeichnet</u>,
daß die Filter dieser Kaskade jeweils als komplexe Halbbandfilter realisiert sind.

## Claims

1. Filter bank for frequency demultiplexing of L channel signals, for L > 0 and L a natural number, comprising L transverse filters (non-recursive filters, filters having a duration of finite length for the pulse response (FIR)), having complex coefficients for real input signals and having complex output signals, and having a sampling rate reduced by the factor M at the output, characterized in that at least one of the L filters is implemented by cascading at least two filters each having complex coefficients, in that for each of these filters ($F_1$ ... $F_q$, ... $F_Q$) the sampling rate is reduced by the factor $M_q > 1$, where

$$\prod_{q=1} M_q = M,$$

in that the input filters ($F_1$) of the cascade respectively receive a real input signal and emit a complex output signal, and in that the other filters of the cascade in each case receive a complex input signal and emit a complex output signal.

2. Filter bank for frequency multiplexing of L channel signals, for L > 0 and L a natural number, comprising L transverse filters (non-recursive filters, filters having a duration of finite length for the pulse response (FIR)), having complex coefficients, for complex input signals and real output signals, and having a sampling rate at the output increased by the factor M, characterized in that at least one of the L filters is implemented by cascading at least two filters each having complex coefficients, in that for each of these filters ($F_1$, ... $F_q$, ... $F_Q$) the sampling rate is increased by the factor $M_q > 1$, where

$$\prod_{q=1} M_q = M,$$

in that the Q-1 first filters ($F_1$, ... $F_q$, ... $F_{Q-1}$) of the cascade in each case receive a complex input signal and emit a complex output signal, and in that the output filters of the cascade in each case receive a complex input signal and emit a real output signal.

3. Filter bank according to Claim 1 or 2, characterized in that the factor M is factorized into two factors by means of a power of two $2^i$ as first factor and a second factor which is equal to $M/2^i$, where i is a natural number.

4. Filter bank according to Claim 3, characterized in that the factor $2^i$ which is a power of two is implemented by a cascade of i filters with in each case $M_q = 2$.

**5.** Filter bank according to Claim 4, characterized in that the filters of this cascade are implemented in each case as complex half-band filters.

## Revendications

**1.** Banc de filtres pour le démultiplexage en fréquence de L signaux de canaux, pour L entier naturel, supérieur à 0, ces bancs se composant de L filtres transversaux (filtres non récurants, filtres à durée de longueur finie pour la réponse impulsionnelle (FIR)), avec des coefficients complexes pour des signaux d'entrée de valeur réelle et des signaux de sortie de valeur complexe, avec une sortie à taux de détection réduit du coefficient M,
caractérisé en ce que
au moins un des L filtres est réalisé par une mise en cascade d'au moins deux filtres ayant chaque fois des coefficients complexes,

- pour chacun de ces filtres ($F_1,...F_q,...F_Q$), le taux de détection est réduit du coefficient $M_q > 1$ ; pour

$$\prod_{q=1}^{\pi} M_q = M \quad,$$

- les filtres d'entrée ($F_1$) de la cascade recevant chaque fois un signal d'entrée de valeur réelle et fournissant un signal de sortie de valeur complexe
- les autres filtres de la cascade reçoivent chaque fois un signal d'entrée de valeur complexe et fournissent un signal de sortie de valeur complexe.

**2.** Banc de filtres pour le multiplexage de fréquences de L signaux de canaux, L étant un nombre naturel > 0, ces bancs se composant de L filtres transversaux (filtres non récurants, filtres à durée de longueur finie pour la réponse impulsionnelle (FIR)), avec des coefficients complexes pour les signaux d'entrée de valeur complexe et des signaux de sortie de valeur réelle, le taux de détection à la sortie étant augmenté du coefficient M,
caractérisé en ce que
au moins l'un des L filtres est réalisé par une mise en cascade d'au moins deux filtres avec chaque fois des coefficients complexes,

- pour chacun de ces filtres ($F_1... F_q... F_Q$), le taux de détection est augmenté du coefficient $M_q > 1$, avec

$$\prod_{q=1}^{\pi} M_q = M \quad,$$

- les Q-1 premiers filtres ($F_1... F_q... F_{Q-1}$), de la cascade, reçoivent chaque fois un signal d'entrée de valeur complexe et fournissent un signal de sortie de valeur complexe, et
- les filtres de sortie de la cascade recevant chaque fois un signal d'entrée de valeur complexe et fournissent un signal de sortie de valeur réelle.

**3.** Banc de filtres selon la revendication 1 ou 2
caractérisé en ce que
le coefficient M est décomposé en deux facteurs avec pour le premier facteur une puissance de $2^i$ et pour le second facteur, une valeur égale à $M/2^i$, i étant égal à un nombre naturel.

**4.** Banc filtre selon la revendication 3
caractérisé en ce que
le coefficient de puissance $2^i$ est réalisé par une cascade de i filtres avec chaque fois $M_q = 2$.

**5.** Banc filtre selon la revendication 4
caractérisé en ce que
les filtres de cette cascade sont réalisés chaque fois sous la forme d'un demi-banc de filtre complexe.

FIG. 1

FIG. 2

FIG. 3

FIG. 4a

FIG. 4b

FIG. 4c

FIG. 4d

FIG. 5

$f_A = \frac{1}{T}$

$h(0) = h_r(0) \left( = \frac{1}{2} \right)$

FIG. 6

$f_A = 1/T$

$\phi = 0$

$(h_i(0) \equiv 0)$